# EUROPEAN PATENT SPECIFICATION

(11) **EP 3 908 783 B1**
(45) Date of publication and mention of the grant of the patent: **14.09.2022**
(21) Application number: 20891427.5
(22) Date of filing: 16.03.2020
(51) Int. Cl.: F21V 15/01, A01G 9/24, F21V 5/00, F21V 31/04

(54) **LIGHT FIXTURE FOR INDOOR GROW APPLICATION**
LEUCHTE ZUR ANWENDUNG FÜR DIE INNENRAUMZÜCHTUNG
APPAREIL D'ÉCLAIRAGE POUR APPLICATION DE CULTURE EN INTÉRIEUR

(43) Date of publication of application: 17.11.2021
(73) Proprietor: HGCI, Inc., Las Vegas, NV 89169 (US)
(72) Inventor: CAI, Dengke, Marysville, OH 43041 (US)
(74) Representative: Forresters IP LLP
(86) International application number: PCT/US2020/022968
(87) International publication number: WO 2021/188091

(56) References cited:
- EP-A1- 2 058 584
- EP-A1- 2 457 016
- US-A- 4 839 553
- US-A1- 2006 187 652
- US-A1- 2011 057 205
- US-A1- 2013 088 882
- US-A1- 2013 293 156
- US-A1- 2019 383 474

## Description

### TECHNICAL FIELD

The apparatus described below generally relates to a light fixture that includes an array of light sources for illuminating an indoor grow facility. Each light source includes a light emitting diode (LED), a lens, an encapsulating material that substantially fills the lens, and a protective coating provided over an exterior surface of the lens.

### BACKGROUND

Indoor grow facilities, such as greenhouses, include light fixtures that provide artificial lighting to plants for encouraging growth. Each of these light fixtures typically includes a plurality of LEDs that generate the artificial light for the plants. EP 2 457 016 A1 discloses an LED system with a sealing membrane disposed between a substrate and a light-shaping panel. US 2013/293156 A1 discloses yet another LED system with a housing that encloses a first and a second LED array. The environment inside these indoor grow facilities, however, can include different types of gasses and/or airborne fluid particles that cause the optical quality of the LEDs to degrade (e.g., yellow) over time. The present invention provides an improved light fixture that solves the needs in the art.

### BRIEF DESCRIPTION OF THE DRAWINGS

Various embodiments will become better understood with regard to the following description, appended claims and accompanying drawings wherein:
FIG. 1 is an upper isometric view depicting a light fixture, in accordance with one embodiment;
FIG. 2 is a lower isometric view of the light fixture of FIG. 1;
FIG. 3 is a partially exploded upper isometric view of the LED light fixture of FIG. 1;
FIG. 4 is a partially exploded lower isometric view of the LED light fixture of FIG. 1;
FIG. 5 is a cross-sectional view taken along the line 5-5 in FIG. 4; and
FIG. 6 is a schematic view of various components of the light fixture of FIG. 1.

### DETAILED DESCRIPTION

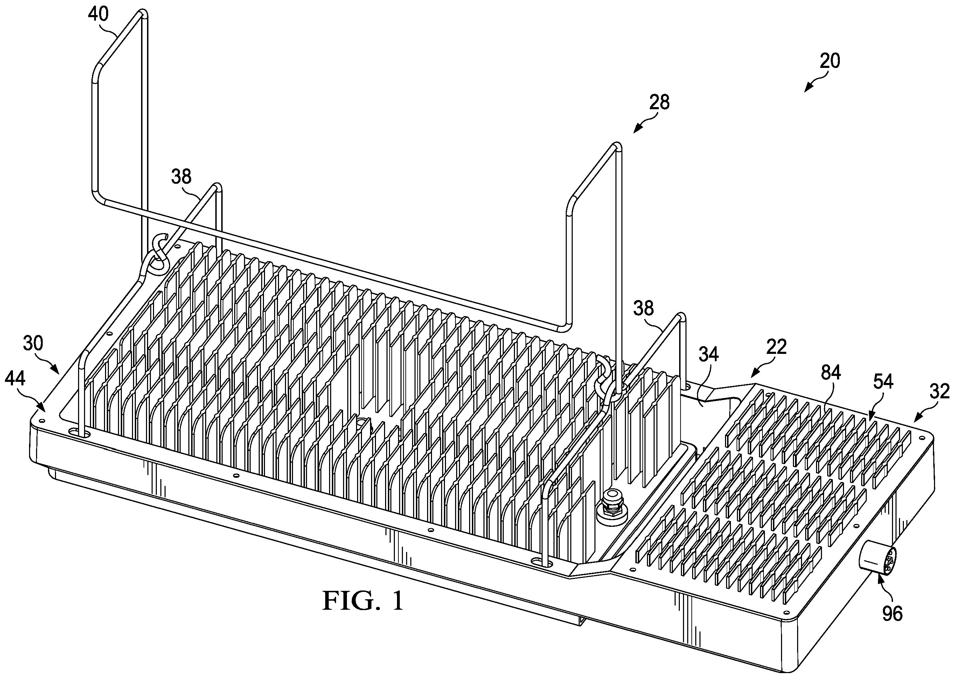

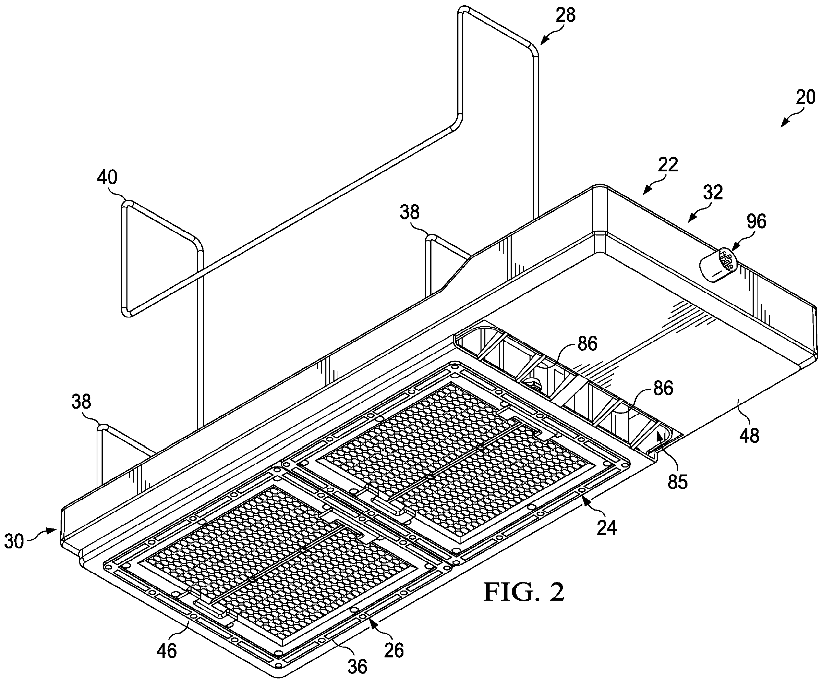

The present invention provides a light fixture according to the appended claims. Embodiments are hereinafter described in detail in connection with the views and examples of FIGS. 1-6, wherein like numbers indicate the same or corresponding elements throughout the views. A light fixture 20 for an indoor grow facility (e.g., a greenhouse) is generally depicted in FIGS. 1 and 2 and can include a housing 22, first and second lighting modules 24, 26 (FIG. 2), and a hanger assembly 28. The housing 22 can include a (second) light support portion 30 and a (first) controller support portion 32 adjacent to the light support portion 30. The light support portion 30 can define a lighting receptacle 34 (FIG. 1) and a window 36 (FIG. 2) disposed beneath the lighting receptacle 34. The first and second lighting modules 24, 26 (FIG. 2) can be disposed within the lighting receptacle 34 above the window 36 and can be configured to emit light through the window 36, as will be described in further detail below.

The hanger assembly 28 can facilitate suspension of the light fixture 20 above one or more plants (not shown) such that light emitted through the window 36 from the first and second lighting modules 24, 26 can be delivered to the underlying plant(s) to stimulate growth. The hanger assembly 28 can include a pair of hanger supports 38 and a hanger bracket 40. The hanger supports 38 can be coupled to the housing 22 on opposing sides of the light fixture 20. The hanger bracket 40 can be coupled with the hanger supports 38 and can extend between the hanger supports 38 to facilitate suspension of the light fixture 20 from a ceiling of the indoor grow facility. As illustrated in FIGS. 1 and 2, the hanger bracket 40 can have a cross-sectional shape that is substantially J-shaped to facilitate selective hanging of the light fixture 20 from a beam or other elongated support member that is provided along a ceiling of the indoor grow facility.

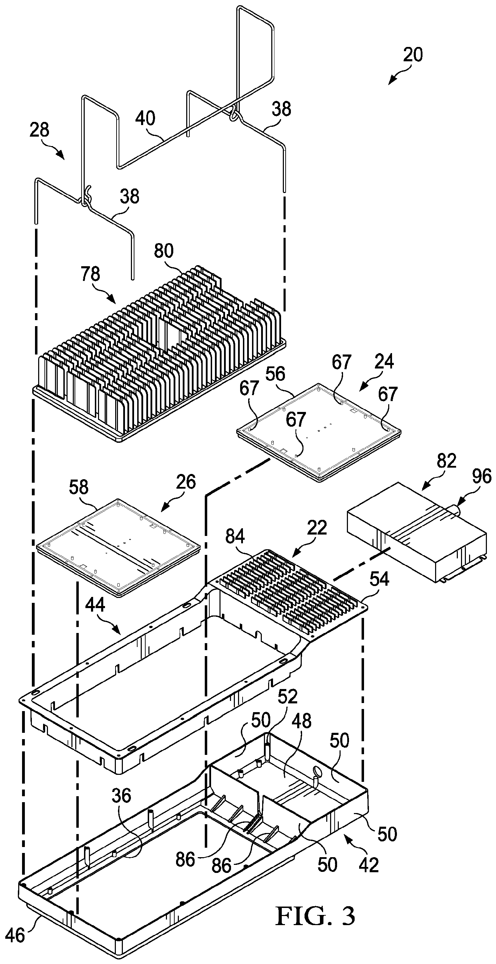

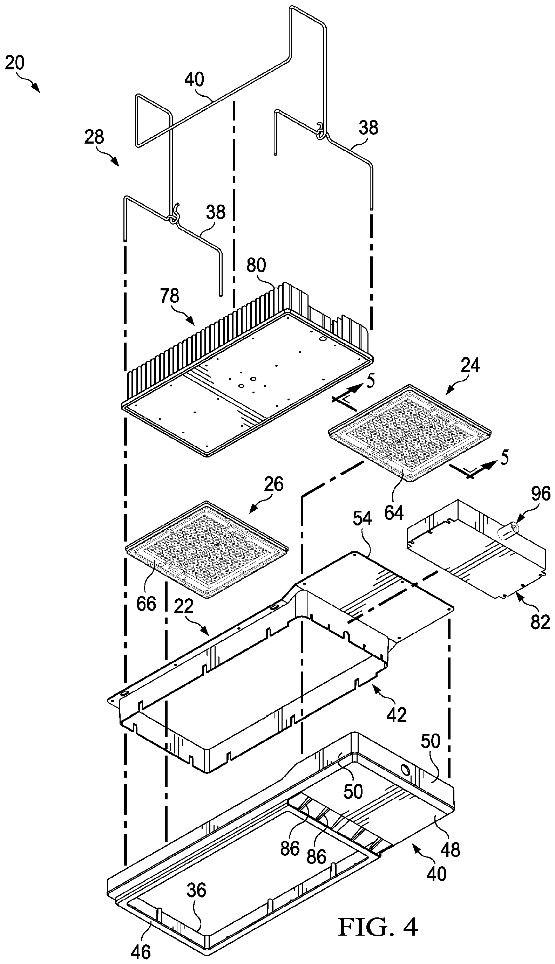

Referring now to FIGS. 3 and 4, the housing 22 can include a main frame 42 and a cover member 44 that overlies the main frame 42 and is coupled together with the main frame 42 via welding, adhesives, releasable tabs (not shown), fasteners (not shown), or any of a variety of suitable alternative permanent or releasable fastening arrangements. The main frame 42 can include a bottom lighting wall 46 that defines the window 36. As illustrated in FIG. 3, the main frame 42 can include a bottom controller wall 48, and a plurality of sidewalls 50 that cooperate to define a controller receptacle 52. The cover member 44 can include a lid portion 54 that overlies and covers the controller receptacle 52, as illustrated in FIG. 1. The bottom controller wall 48, the sidewalls 50, and the lid portion 54 can form at least part of the controller support portion 32 of the housing 22.

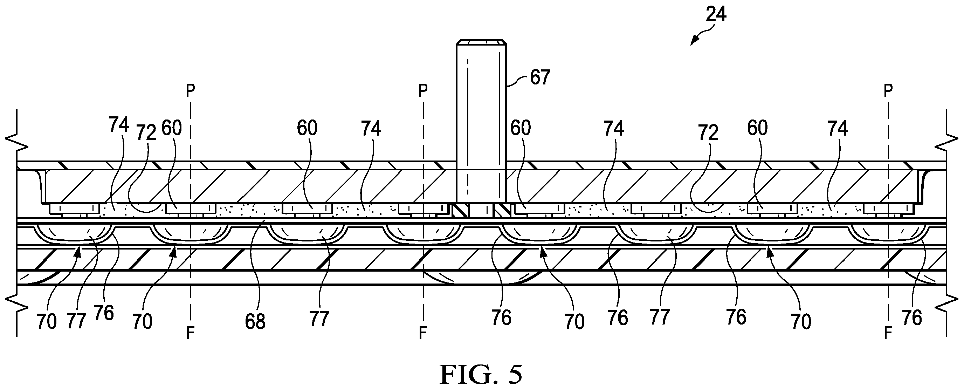

As illustrated in FIG. 4, the first and second lighting modules 24, 26 can each include a submount 56, 58, a plurality of light emitting diodes (LEDs) (e.g., 60 in FIG. 5), and a lens cover 64, 66. Referring to FIG. 5, the first lighting module 24 will now be discussed, but can be understood to be representative of the second lighting module 26. The LEDs 60 can comprise surface mount LEDs that are mounted to the submount 56 via any of a variety of methods or techniques commonly known in the art. The LEDs 60 can be any of a variety of suitable configurations that are mounted directly or indirectly to the submount 56. The LEDs 60 can comprise single color LEDs (e.g., capable of emitting only one color of light such as white, red or blue), multi-color LEDs (e.g., capable of emitting different colors such as white, red, and blue) or a combination of both. The submount 56 can be formed of any of a variety of thermally conductive materials that are suitable for physically and thermally supporting the LEDs 60.

The lens cover 64 can overlie the submount 56 and the LEDs 60 and can be coupled with the submount 56 with fasteners 67 or any of a variety of suitable alternative coupling arrangements. The lens cover 64 can include a base substrate 68 that is substantially planar and a plurality of optical lens elements 70 that protrude from the base substrate 68. Each of the optical lens elements 70 can be substantially aligned with respective ones of the LEDs 60 and can be configured to redistribute (e.g., concentrate or disperse) the light emitted from the LEDs 60 towards an area beneath the light fixture 20 (e.g., towards one or more plants). As illustrated in FIGS. 4 and 5, each of the optical lens elements 70 can have an indented oval shape. However, the optical lens elements 70 can be any of a variety of suitable alternative shapes or combinations thereof for achieving a desired redistribution of light emitted from the LEDs 60.

As illustrated in FIG. 5, the LEDs 60 can each be aligned with respective ones of the optical lens elements 70 such that the physical center P and the focal center F are coaxial. In another embodiment, the LEDs 60 can each be slightly offset with respective ones of the optical lens elements 70 such that the physical center P and the focal center F are non-coaxial. In one embodiment, the lens cover 64 can have a unitary one-piece construction formed of a polycarbonate material and/or polymethyl methacrylate (PMMA). It is to be appreciated, however, that the lens cover 64 can be formed of any of a variety of suitable alternative translucent or transparent materials that can protect underlying LEDs from environmental conditions and can also accommodate a plurality of optical lens elements 70 for redistributing light transmitted from underlying LEDs.

The lens cover 64 can be spaced from the submount 56 such that the lens cover 64 and the submount 56 cooperate to define an interior 72 therebetween. An encapsulating material 74 can be provided within the interior 72 such that the encapsulating material 74 substantially fills the interior 72 and encapsulates the LEDs 60 therein. The encapsulating material 74 can be formed of an optically neutral (or enhancing) material that reduces optical loss in the interior 72 that might otherwise occur without the encapsulating material 74 (e.g., if there was air in the interior 72). The interior 72 can be filled with enough of the encapsulating material 74 (e.g., filled entirely) to cause the interior 72 to be substantially devoid of air bubbles or other media that would adversely affect the optical integrity between the LEDs 60 and the lens cover 64. The encapsulating material 74 can also protect the LEDs 60 from environmental conditions that might be able to bypass the lens cover 64 such as a gaseous fluid (e.g., greenhouse gas). In one embodiment, the encapsulating material 74 can be a silicone gel such as a methyl type silicone (e.g., polydimethylsiloxane) or a phenyl-type silicone, for example, that has a refractive index of between about 1.35 and 1.6. It is to be appreciated that any of a variety of suitable alternative materials are contemplated for the encapsulating material 74.

The encapsulating material 74 can be substantially softer than the lens cover 64 (e.g., the encapsulating material 74 can have a hardness that is less than a hardness of the lens cover 64). The encapsulating material 74 can be a flowable material, such as a fluid or gel that can be injected or otherwise dispensed into the interior 72 after the lens cover 64 is assembled on the submount 56. In another embodiment, the encapsulating material 74 can be coated onto the lens cover 64 and/or over the submount 56 and LEDs 60 prior to assembling the lens cover 64 on the submount 56.

Still referring to FIG. 5, a protective coating 76 can be provided over an exterior surface 77 of the lens cover 64. The protective coating 76 can be hydrophobic, oleophobic, and/or chemically resistant such that the exterior surface of the lens cover 64 is protected from harmful environmental conditions that might otherwise adversely affect the optical performance of the optical lens elements 70. The protective coating 76 can additionally or alternatively optically enhance the transmission quality of the optical lens elements 70. In one embodiment, the protective coating 76 can be a thin-film inorganic material that protects against environmental conditions (e.g., chemical etching) and also improves overall transmission quality of the optical lens elements 70. The thin-film inorganic material can be between about 10 nm and about 200 nm thick and can have a refractive index above about 1.49. Some examples of suitable thin-film inorganic materials include MgF2, CaF2, SiO2, Al2O3 and/or TiO2. Although the protective coating 76 is shown to be a single layer arrangement, it is to be appreciated that the protective coating 76 can alternatively be a multi-layer arrangement that is either homogenous (multiple layers of the same material) or heterogeneous (multiple layers of different material).

It is to be appreciated that the light emitted by the first lighting module 24 can conform to a lighting profile (e.g., range of color, overall distribution of light, heat profile) that is defined by the physical configuration of the first lighting module 24 (e.g., the types of LEDs 60 that are utilized (e.g., single color or multi color), the physical layout of the LEDs 60, the optics provided by the lens elements (e.g., 68), the encapsulating material (e.g., 74), the protective coating (e.g., 76), and the overall power consumption). Although various examples of the physical configuration of the first lighting module are described above and shown in the figures, it is to be appreciated that any of a variety of suitable alternative physical configurations of the first lighting module 24 are contemplated for achieving a desired lighting profile.

Referring now to FIGS. 1 and 3, a heat sink 78 can be disposed over each of the first and second lighting modules 24, 26 and can be configured to dissipate heat away from the first and second lighting modules 24, 26. The heat sink 78 can be formed of any of a variety of a thermally conductive materials, such as aluminum or copper, for example. The heat sink 78 can be in contact with the submounts 56, 58 on an opposite side from the LEDs (e.g., 60). Heat generated by the LEDs (e.g., 60) can be transferred from the submounts 56, 58 to the heat sink 78 and dissipated to the surrounding environment by a plurality of fins 80. A heat sink compound (not shown), such as thermal paste, for example, can be provided between the submounts 56, 58 and the heat sink 78 to enhance the thermal conductivity therebetween. Although the heat sink 78 is shown to be a unitary component that is provided over the first and second lighting modules 24, 26, it is to be appreciated that dedicated heat sinks can alternatively be provided for each of the first and second lighting modules 24, 26.

Referring now to FIG. 3, a controller 82 can be disposed in the controller receptacle 52 and can be configured to power and control the first and second lighting modules 24, 26. As illustrated in FIG. 1, the lid portion 54 of the cover member 44 can overlie the controller receptacle 52 and the controller 82. The lid portion 54 can serve as a heat sink for the controller 82 and can include a plurality of fins 84 to facilitate dissipation of heat from the controller 82. A heat sink compound (not shown), such as thermal paste, for example, can be provided between the lid portion 54 and the controller 82 to enhance the thermal conductivity therebetween. The main frame 42 and the cover member 44 can each be formed of a thermally conductive material such as aluminum, for example. Heat from the first and second lighting modules 24, 26 and the controller 82 can be transmitted throughout the housing 22 to effectively supplement the cooling properties of the heat sink 78 and the lid portion 54.

Referring now to FIGS. 1 and 2, the housing 22 can define a passageway 85 that extends between the light support portion 30 and the controller support portion 32 such that the first and second lighting modules 24, 26 and the controller 82 are physically spaced from each other. The passageway 85 can be configured to allow air to flow between the light support portion 30 and the controller support portion 32 to enhance cooling of the first and second lighting modules 24, 26 and the controller 82 during operation. As illustrated in FIG. 3, the housing 22 can comprise a plurality of rib members 86 that extend between the light support portion 30 and the controller support portion 32 to provide structural rigidity therebetween.

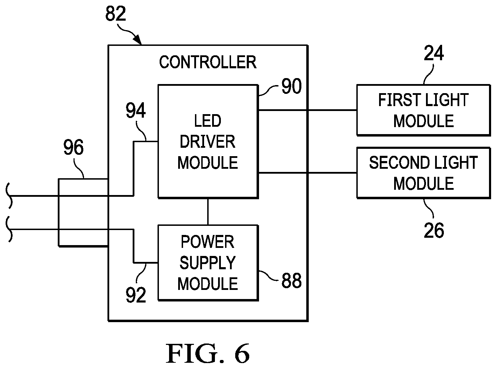

Referring now to FIG. 6, the controller 82 can include a power supply module 88 and an LED driver module 90. The power supply module 88 can be coupled with the LED driver module 90, and the LED driver module 90 can be coupled with each of the first and second lighting modules 24, 26 (e.g., in parallel). The power supply module 88 can include a power input 92 that is coupled with a power source (not shown), such as an A/C power source, for delivering external power to the power supply module 88 for powering the first and second lighting modules 24, 26. The power supply module 88 can be configured to condition the external power from the power source (e.g., transform AC power to DC power) to facilitate powering of the LEDs (e.g., 60). The light fixture 20 can be configured to operate at an input power of between about 85 VAC and about 347 VAC (e.g., a 750 Watt load capacity).

The LED driver module 90 can include a control input 94 that is coupled with a control source (not shown), such as a greenhouse controller, for example, that delivers a control signal to the LED driver module 90 for controlling the first and second lighting modules 24, 26, as will be described in further detail below. The LED driver module 90 can be configured to communicate according to any of a variety if suitable signal protocols, such as BACnet, ModBus, or RS485, for example.

The power input 92 and the control input 94 can be routed to a socket 96 (FIGS. 2 and 6) that is configured to interface with a plug (not shown) that can deliver the external power and control signals to the power supply module 88 and the LED driver module 90, respectively. The socket 96 can be a Wieland-type connector, although other connector types are contemplated. It is to be appreciated that although the power and control signals are shown to be delivered through the socket 96 (e.g., via the same cable), the light fixture 20 can alternatively include separate ports for the power and the control signal such that the power and the control signal are transmitted to the power supply module 88 and the LED driver module 90 along different cables.

The LED driver module 90 can be configured to control one or more of the intensity, color, and spectrum of the light generated by the LEDs (e.g., 60) as a function of time (e.g., a light recipe). The LED driver module 90 can control the light recipe of the first and second lighting modules 24, 26 independently such that the first and second lighting modules 24, 26 define respective first and second lighting zones that are independently controllable within the lighting environment. The light recipes of the first and second lighting zones can accordingly be tailored to accommodate the lighting requirements of plants that are provided within the lighting environment. For example, when the plants provided in each of the first and second lighting zones are the same (or have similar lighting requirements), the respective light recipes for the first and second lighting modules 24, 26 can be the same to provide a substantially uniform lighting environment between the first and second lighting zones. When a group of plants provided in the first lighting zone has a different lighting requirement from a group of plants provided in the second lighting zone, the respective light recipes for the first and second lighting modules 24, 26 can be tailored to accommodate the different lighting requirements between the groups of plants. The first and second lighting modules 24, 26 can have unique addresses such that the control signal can assign separate lighting recipes to each of the first and second lighting modules 24, 26 (via the LED driver module 90) based upon their unique addresses. It is to be appreciated, that although the LED driver module 90 is described as being configured to control the light recipe of each of the first and second lighting modules 24, 26, the LED driver module 90 can additionally or alternatively be configured to control any of a variety of suitable alternative variable lighting features of the first and second lighting modules 24, 26 (e.g., any lighting feature that can be controlled in real time with a control signal).

The first and second lighting modules 24, 26 can be self-contained, stand-alone units that are physically separate from each other. As such, the physical configuration and variable lighting features of each of the first and second lighting modules 24, 26 can be individually selected to allow the first and second lighting zones to be customized to achieve a desired lighting environment. The first and second lighting modules 24, 26 can be exchanged with different lighting modules during the life cycle of a plant to optimize the lighting environment for the plant throughout its life cycle.

## Claims

1. A light fixture (20) for an indoor growing facility, the light fixture (20) comprising:
a housing (22) comprising a first portion (32) and a second portion (30);
the second portion (30) defining a window (36);
a controller (82) at least partially disposed within the first portion (32) and
a lighting module (24, 26) at least partially disposed in the second portion (30), the lighting module (24, 26) comprising:
a submount (56, 58);
a plurality of light emitting diodes (60) coupled with the submount (56, 58) and configured to project light through the window (36);
a lens cover (64) comprising a base substrate (68), a plurality of lens elements (70) protruding from the base substrate (68), and an exterior surface (77), the lens cover (64) overlying the plurality of light emitting diodes (60) and the submount (56, 58) such that the lens cover (64) and the submount (56, 58) define an interior (72) therebetween;
an encapsulating material (74) that substantially fills the interior (72) and encapsulates the plurality of light emitting diodes (60); and
a protective coating (76) provided over the exterior surface (77) of the lens cover (64), wherein:
the lens cover (64) has a first hardness;
the encapsulating material (74) has a second hardness that is less than the first hardness; and
each light emitting diode of the plurality of light emitting diodes (60) is aligned with respective lens elements (70) of the plurality of the lens elements (70).

2. The light fixture (20) of claim 1 wherein the second hardness is a Shore A of less than 70.

3. The light fixture (20) of claim 2 wherein the encapsulating material (74) comprises a silicone gel.

4. The light fixture (20) of claims 1-3 wherein the lens cover (64) is formed of a polycarbonate or polymethyl methacrylate.

5. The light fixture (20) of claims 1-4 wherein the protective coating comprises an inorganic thin film coating.

6. The light fixture (20) of claim 5 wherein the inorganic thin film coating comprises one or more of magnesium fluoride, calcium fluoride, silicon dioxide, aluminum oxide and titanium dioxide.

7. The light fixture (20) of claim 5 wherein the protective coating has a thickness of between about 10 nm and about 200 nm.

8. The light fixture (20) of claims 2-7 wherein the housing (22) defines a passageway (85) between the first portion (32) and the second portion (30).

9. The light fixture (20) of claim 8 further comprising a plurality of rib members (86) that extend between the first portion (32) and the second portion (30) and are at least partially disposed in the passageway (85).

10. The light fixture (20) of claims 1-9 wherein:
each light emitting diode (60) of the plurality of light emitting diodes (60) comprises a physical center (P);
each lens element (70) of the plurality of lens elements (70) comprises a focal center (F); and the physical center (P) of each light emitting diode (60) of the plurality of light emitting diodes (60) is coaxial
with the focal center (F) of the respective lens elements (70) of the plurality of the lens elements (70).

## Patentansprüche

1. Beleuchtungsarmatur (20) für eine Innenanbauanlage, wobei die Beleuchtungsarmatur (20) umfasst:
ein Gehäuse (22), das einen ersten Abschnitt (32) und einen zweiten Abschnitt (30) umfasst; wobei der zweite Abschnitt (30) ein Fenster (36) definiert;
ein Steuergerät (82), das mindestens teilweise innerhalb des ersten Abschnitts (32) angeordnet ist, und
ein Beleuchtungsmodul (24, 26), das mindestens teilweise in dem zweiten Abschnitt (30) angeordnet ist, wobei das Beleuchtungsmodul (24, 26) umfasst:
eine Basisplatte (56, 58);
eine Vielzahl von Leuchtdioden (60), die mit der Basisplatte (56, 58) gekoppelt sind und konfiguriert sind, um Licht durch das Fenster (36) hindurch zu projizieren;
eine Linsenabdeckung (64), die ein Basissubstrat (68) umfasst, eine Vielzahl von Linsenelementen (70), die aus dem Basissubstrat (68) vorstehen, und eine äußere Oberfläche (77), wobei die Linsenabdeckung (64) die Vielzahl von Leuchtdioden (60) und die Basisplatte (56, 58) derart überlagert, dass die Linsenabdeckung (64) und die Basisplatte (56, 58) dazwischen einen Innenraum (72) definieren;
ein Vergussmaterial (74), das im Wesentlichen den Innenraum (72) ausfüllt und die Vielzahl von Leuchtdioden (60) vergießt; und
eine Schutzbeschichtung (76), die über der äußeren Oberfläche (77) der Linsenabdeckung (64) bereitgestellt wird, wobei:
die Linsenabdeckung (64) eine erste Härte aufweist;
das Vergussmaterial (74) eine zweite Härte aufweist, die geringer als die erste Härte ist; und
jede Leuchtdiode der Vielzahl von Leuchtdioden (60) auf jeweilige Linsenelemente (70) der Vielzahl von Linsenelementen (70) ausgerichtet ist.

2. Beleuchtungsarmatur (20) nach Anspruch 1, wobei die zweite Härte ein Shore A von weniger als 70 ist.

3. Beleuchtungsarmatur (20) nach Anspruch 2, wobei das Vergussmaterial (74) ein Silikongel umfasst.

4. Beleuchtungsarmatur (20) nach Anspruch 1 bis 3, wobei die Linsenabdeckung (64) aus einem Polycarbonat oder Polymethylmethacrylat gebildet ist.

5. Beleuchtungsarmatur (20) nach Anspruch 1 bis 4, wobei die Schutzbeschichtung eine anorganische Dünnfilmbeschichtung umfasst.

6. Beleuchtungsarmatur (20) nach Anspruch 5, wobei die anorganische Dünnfilmbeschichtung eines oder mehrere von Magnesiumfluorid, Kalziumfluorid, Siliziumdioxid, Aluminiumoxid und Titandioxid umfasst.

7. Beleuchtungsarmatur (20) nach Anspruch 5, wobei die Schutzbeschichtung eine Dicke zwischen ungefähr 10 nm und ungefähr 200 nm aufweist.

8. Beleuchtungsarmatur (20) nach Anspruch 2 bis 7, wobei das Gehäuse (22) einen Durchgang (85) zwischen dem ersten Abschnitt (32) und dem zweiten Abschnitt (30) definiert.

9. Beleuchtungsarmatur (20) nach Anspruch 8, ferner umfassend eine Vielzahl von Rippenelementen (86), die sich zwischen dem ersten Abschnitt (32) und dem zweiten Abschnitt (30) erstrecken, und mindestens teilweise in dem Durchgang (85) angeordnet sind.

10. Beleuchtungsarmatur (20) nach Anspruch 1 bis 9, wobei:
jede Leuchtdiode (60) der Vielzahl von Leuchtdioden (60) einen physikalischen Mittelpunkt (P) umfasst;
jedes Linsenelement (70) der Vielzahl von Linsenelementen (70) einen Brennpunkt (F) umfasst; und
der physikalische Mittelpunkt (P) jeder Leuchtdiode (60) der Vielzahl von Leuchtdioden (60) zu dem Brennpunkt (F) der jeweiligen Linsenelemente (70) der Vielzahl von Linsenelementen (70) koaxial ist.

## Revendications

1. Appareil d'éclairage (20) destiné à une installation de culture en intérieur, l'appareil d'éclairage (20) comprenant :
un boîtier (22) comprenant une première partie (32) et une seconde partie (30) ;
la seconde partie (30) définissant une fenêtre (36) ;
un dispositif de commande (82) au moins partiellement disposé dans la première partie (32) et
un module d'éclairage (24, 26) au moins partiellement disposé dans la seconde partie (30), le module d'éclairage (24, 26) comprenant :
une embase (56, 58) ;
une pluralité de diodes électroluminescentes (60) couplées à l'embase (56, 58) et conçues pour projeter de la lumière à travers la fenêtre (36) ;
un couvercle de lentille (64) comprenant un substrat de base (68), une pluralité d'éléments de lentille (70) faisant saillie à partir du substrat de base (68) et une surface extérieure (77), le couvercle de lentille (64) recouvrant la pluralité de diodes électroluminescentes (60) et l'embase (56, 58) de sorte que le couvercle de lentille (64) et l'embase (56, 58) définissent un espace intérieur (72) entre ceux-ci ;
un matériau d'encapsulation (74) qui remplit sensiblement l'espace intérieur (72) et encapsule la pluralité de diodes électroluminescentes (60) ; et
un revêtement protecteur (76) prévu sur la surface extérieure (77) du couvercle de lentille (64), dans lequel :
le couvercle de lentille (64) a une première dureté ;
le matériau d'encapsulation (74) a une seconde dureté qui est inférieure à la première dureté ; et
chaque diode électroluminescente parmi la pluralité de diodes électroluminescentes (60) est alignée avec des éléments de lentille (70) respectifs parmi la pluralité d'éléments de lentille (70).

2. Appareil d'éclairage (20) selon la revendication 1 dans lequel la seconde dureté est une dureté Shore A inférieure à 70.

3. Appareil d'éclairage (20) selon la revendication 2 dans lequel le matériau d'encapsulation (74) comprend un gel de silicone.

4. Appareil d'éclairage (20) selon les revendications 1 à 3 dans lequel le couvercle de lentille (64) est constitué d'un polycarbonate ou d'un polyméthacrylate de méthyle.

5. Appareil d'éclairage (20) selon les revendications 1 à 4 dans lequel le revêtement protecteur comprend un revêtement de film mince inorganique.

6. Appareil d'éclairage (20) selon la revendication 5 dans lequel le revêtement de film mince inorganique est constitué d'un ou de plusieurs éléments parmi le fluorure de magnésium, le fluorure de calcium, le dioxyde de silicium, l'oxyde d'aluminium et le dioxyde de titane.

7. Appareil d'éclairage (20) selon la revendication 5 dans lequel le revêtement protecteur a une épaisseur comprise entre environ 10 nm et environ 200 nm.

8. Appareil d'éclairage (20) selon les revendications 2 à 7 dans lequel le boîtier (22) définit un passage (85) entre la première partie (32) et la seconde partie (30).

9. Appareil d'éclairage (20) selon la revendication 8 comprenant en outre une pluralité d'éléments de nervure (86) qui s'étendent entre la première partie (32) et la seconde partie (30) et qui sont au moins partiellement disposés dans le passage (85).

10. Appareil d'éclairage (20) selon les revendications 1 à 9 dans lequel :
chaque diode électroluminescente (60) parmi la pluralité de diodes électroluminescentes (60) comprend un centre physique (P) ;
chaque élément de lentille (70) parmi la pluralité d'éléments de lentille (70) comprend un centre focal (F) ; et
le centre physique (P) de chaque diode électroluminescente (60) parmi la pluralité de diodes électroluminescentes (60) est coaxial au centre focal (F) des éléments de lentille (70) respectifs parmi la pluralité d'éléments de lentille (70).
